(19) Europäisches Patentamt European Patent Office Office européen des brevets

(11) **EP 4 578 911 A1**

(12) **EUROPEAN PATENT APPLICATION**

(43) Date of publication:
02.07.2025 Bulletin 2025/27

(21) Application number: 23220452.9

(22) Date of filing: 28.12.2023

(51) International Patent Classification (IPC):
**C08L 23/14** *(2006.01)* **C08L 53/00** *(2006.01)*
**C08L 87/00** *(2006.01)*

(52) Cooperative Patent Classification (CPC):
(C-Sets available)
**C08L 23/14**; C08L 2203/20 (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: SHPP Global Technologies B.V.
4612 PX Bergen op Zoom (NL)

(72) Inventors:
• JIANG, Xiaoming
Shanghai (CN)
• CHIKU, Yukiyoshi
Tochigi, 321-4392 (JP)
• UCHIYAMA, Tatsuya
Tochigi, 321-4392 (JP)

(74) Representative: **Modiano, Gabriella Diana et al**
**Modiano & Partners SA**
**Steinsdorfstraße 14**
**80538 München (DE)**

(54) **HIGH IMPACT COLORABLE ESD POLYPROPYLENE COMPOSITIONS AND ARTICLES**

(57) Compositions include from about 65 wt% to about 90 wt% of a polypropylene resin, and from about 8 wt% to about 35 wt% of an inherently dissipative polymer (IDP). The IDP includes a polyether-polyolefin block copolymer. The combined weight percent value of all components does not exceed 100 wt %, all weight percent values are based on the total weight of the composition. The composition may exhibit a surface resistivity less than $9.0 \times 10^9$ Q when tested in accordance with ANSI/ESD STM 11.13. Methods of forming the compositions are also described.

## Table 1. Materials

| Component | Description | Supplier |
|---|---|---|
| IDP1 | PP-co-PEO based – non-functionalized inherently dissipative polymer; polypropylene copolymer polyetherolefin based; (Pelectron™ PVL); not ion-doped | Sanyo Chemical |
| PP1 | Polypropylene copolymer (ethylene-propylene copolymer); Melt flow rate of about 10 g/10 min. (NOVATEC-PP BC3AD) | Japanese Polypropylene Corporation |
| PP2 | Polypropylene copolymer (ethylene-propylene copolymer); melt flow rate of about 11 g/10 min. (Pro-fax SR549M, L850050) | Lyondell Basell |
| IDP2 | Nylon-co-PEO based – inherently dissipative polymer; nylon copolymer with polyetherolefin (Pelestat™ NC632); sodium ion doped | Sanyo Chemical |
| IM1 | chemically modified polypropylene copolymer impact modifier ; FUSABOND™ P353; Phenol, 4,4 -(1-methylethylidene)bis-, polymer with 1,1 -sulfonylbis[4-chlorobenzene], CAS number 31069-12-2 | Dupont |
| AO | Anti-oxidant IRGANOX™ 1010 | BASF |

**FIG. 1**

EP 4 578 911 A1

(52) Cooperative Patent Classification (CPC): (Cont.)

C-Sets
**C08L 23/14, C08L 53/00;**
**C08L 23/14, C08L 87/005**

**Description**

**FIELD OF THE DISCLOSURE**

The present disclosure relates to materials including polypropylene compositions, and in particular to polypropylene compositions suitable for electrostatic dissipation applications.

**BACKGROUND**

Electro-static dissipative (ESD) and anti-static materials are widely used to prevent electro-static accumulation across various applications including semi-conductors, consumer electronics, and industrial constructions. Such materials may be defined by their values for surface resistivity (SR), namely, ESD materials having an SR between E+6 and E+9 (or $1 \times 10^6$ and $1 \times 10^9$) ohms and anti-static materials having an SR between is E+10 and E+12 ohms (or $1 \times 10^{10}$ and $1 \times 10^{12}$). Generally, ESD properties in a given material may be achieved by the incorporation of various carbon fillers such as carbon fiber, conductive carbon black, graphite, graphene, carbon nanotube. These carbon fillers, however, are naturally black or dark and are typically expensive. Other approaches to achieve ESD performance include the use of inherently dissipative polymer (IDP). While the use of IDP may provide sufficiently high surface resistivity, impact strength may be undesirably low. As an example, conventional polypropylene ESD materials are often dark in color limiting the available color space for certain applications. Furthermore, many higher molecular weight ESD reagents are not miscible with certain substrates or matrix polymers used. And, where polypropylene ESD materials include an IDP, the traditionally used IDPs are generally incompatible with the polypropylene base resin and result in compositions with SR values beyond the values for ESD performance.

Accordingly, there remains a need in the art for colorable ESD polypropylene based compositions that maintain desirable mechanical properties and have a low leachable ion content and low gassing.

**SUMMARY**

The above-described and other deficiencies of the art are met by thermoplastic compositions including: (a) from about 65 wt% to about 90 wt% of a polypropylene resin; and from about 8 wt% to about 35 wt% of an inherently dissipative polymer (IDP). The IDP includes a polyether-polyolefin block copolymer. The combined weight percent value of all components does not exceed 100 wt %, all weight percent values are based on the total weight of the composition, and the composition exhibits a surface resistivity less than $9.0 \times 10^9$ $\Omega$ when tested in accordance with ANSI/ESD STM 11.13.

The above described and other features are exemplified by the following detailed description, examples, and claims.

**BRIEF DESCRIPTION OF ILLUSTRATIVE DRAWINGS**

The accompanying figures, which are incorporated in and constitute a part of this specification, illustrate several aspects and together with the description explain the principles of the of the disclosure.

FIG. 1 presents Table 1 showing the materials used for formulations presented herein.

FIG. 2 presents Table 4A showing the formulations.

FIG. 3A presents Table 4B showing certain observed properties for the formulations.

FIG. 3B presents Table 4C showing other observed properties for the formulations.

**DETAILED DESCRIPTION OF ILLUSTRATIVE ASPECTS**

The present disclosure may be understood more readily by reference to the following detailed description of desired aspects and the examples included therein. In the following specification and the claims that follow, reference will be made to a number of terms which have the following meanings. Also, within the scope of the disclosure are articles of manufacture prepared according to any of the methods described herein. For example, articles that can be produced using the materials and methods of the disclosure include those in the electrical field, for example, computer, antenna and lighting articles.

Electrically conductive fillers can be introduced in polymer compositions to provide electrostatic dissipative materials that prevent the accumulation of potentially dangerous charges. These ESD materials slow down the flow of electric charges allowing the charges to flow to ground more slowly and may be characterized by a surface resistivity of from E+6 to E+9 ohms. Comparatively, antistatic materials prevent the buildup of a static electric charge and have a surface resistivity of E+10 and E+12 ohms. The desired ESD performance (and SR values) may be achieved using various carbon fillers including, but not limited to, carbon fiber, conductive carbon black, graphite, graphene, carbon nanotubes. These carbon fillers are often expensive and typically black or darkly colored thereby limiting their use in certain applications. Alternatively, inherently dissipative polymer (IDP) may be incorporated to provide sufficient ESD performance, but other composition properties may suffer. but in that case the surface resistivity is usually high and impact strength is low. For example, conventional polypropylene-based ESD materials often include black or dark colored carbon filler such as conductive carbon black and/or carbon fiber to achieve ESD performance. Moreover, given the intrinsically high surface resistivity (SR) of nylon-co-PEO type IDP (that is, about 1.0 E+9 S2), the conductivity of PP based compounds would not meet the SR levels to qualify as ESD performing because the SR value is less than or equal to E+9 S2. PP-based compositions combined with nylon-co-PEO type IDP also suffer from reduced toughness or a lower notched Izod impact strength, even where an impact modifier is included.

There have been attempts to relieve the issues associated with polyolefin based materials for ESD applications. Japanese Published Application JP2008297418A discloses combinations of polyphenylene block copolymers and inherently dissipative materials included of a) polyamide or polyolefin and b) polyether and/or polyester. The compositions disclosed in the publication however are antistatic resins rather than ESD.

Japanese Patent Number JP04451646B2 similarly discloses an antistatic composition including a block polyolefin and a hydrophilic polymer. Japanese Published Patent Application JP2006265540A further describes an antistatic composition including a block polyolefin based hydrophilic chain strand polymer composition.

Japanese Published Application JP2011006670A discloses an antistatic agent including a hydrophobic polymer, such as a polyamide and polyolefin, and a hydrophilic polymer, such as a polyether. The antistatic agent is combined with a suitable thermoplastic resin.

Chinese Patent 1412086A discloses an antistatic separate sheet including a polyolefin-based resin and a composition including a polymer resin essentially having both polyolefin-based skeleton and a hydrophilic polymer skeleton.

Compositions of the present disclosure overcome existing shortcomings of conventional polypropylene-based ESD materials. The disclosed formulations achieve both ESD and broad coloring potential while also maintaining desirable impact performance and clean processing parameters.

The disclosed compositions combine polypropylene polymer and a polypropylene based inherently dissipative polymer (IDP) to provide high impact, colorable materials, which may be a suitable replacement for carbon filled ESD materials in the market, especially for the semi-conductor industry. The compositions including PP homo/copolymer and PP-co-PEO based IDP offer low surface resistivity (SR) down to E+8-E+9 ohms qualifying for ESD application while keeps its appearance colorable and high impact strength is achieved; and by using unique clean compounding technique high cleanliness is reached. The disclosed compositions may be colorable in that they have sufficient color space and are not too dark in color to accept suitable colorant or pigment for varying applications. These compositions have a sufficiently high color coordinate value to accommodate custom coloring. In further aspects, the disclosed ESD compositions further provide a clean solution to the outstanding need for colorable polypropylene based ESD materials. The materials may exhibit a low leachable ion content and total outgassing.

Aspects of the present disclosure may resolve many of the above-described technical limitations associated with polypropylene-based ESD materials while also exhibiting sufficient cleanliness with respect to ion leaching and total gassing. Compositions according to aspects of the disclosure exhibit improved properties as compared to conventional polypropylene based ESD materials that include a traditional nylon based IDP material. As provided herein, improved properties include, but are not limited to, mechanical properties such as impact strength, as well as colorability. Compositions of the present disclosure may include from about 65 wt% to about 90 wt% of a polypropylene resin; from about 8 wt% to about 35 wt% of an inherently dissipative polymer (IDP). The IDP includes a polyether olefin based polymer; and optionally from about 0.01 wt% to about 0.5 wt% of an antioxidant. The combined weight percent value of all components does not exceed 100 wt %, all weight percent values are based on the total weight of the composition.

Before the present compounds, compositions, articles, systems, devices, and/or methods are disclosed and described, it is to be understood that they are not limited to specific synthetic methods unless otherwise specified, or to particular reagents unless otherwise specified, as such can, of course, vary. It is also to be understood that the terminology used herein is for the purpose of describing particular aspects only and is not intended to be limiting. Various combinations of elements of this disclosure are encompassed by this disclosure, for example, combinations of elements from dependent claims that depend upon the same independent claim.

Moreover, it is to be understood that unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is no way intended that an order be inferred, in any respect.

This holds for any possible non-express basis for interpretation, including matters of logic with respect to arrangement of steps or operational flow; plain meaning derived from grammatical organization or punctuation; and the number or type of aspects described in the specification.

## *Thermoplastic Compositions*

The disclosed compositions may include a polypropylene resin, an inherently dissipative polymer (IDP), and, optionally, an antioxidant. In certain aspects, the composition includes from about 65 wt% to about 90 wt% of a polypropylene resin; from about 8 wt% to about 30 wt% of an inherently dissipative polymer (IDP). The IDP includes a polyether olefin based polymer. The combined weight percent value of all components does not exceed 100 wt %, all weight percent values are based on the total weight of the composition. The compositions may exhibit a surface resistivity less than less than or equal to $9.0 \times 10^9$ $\Omega$ when tested in accordance with ANSI/ESD STM 11.13.

The polypropylene polymer may include a homopolymer or a copolymer. In further aspects, polypropylene includes a copolymer.

In some aspects, the inherently dissipative polymer may include a polyether olefin based polymer or a polyether-polyolefin block copolymer.

Compositions according to aspects of the disclosure have improved properties as compared to polypropylene resins including a nylon based IDP and carbon-based filler. Improved properties include, but are not limited to, impact performance and colorability. Furthermore, the compositions achieve these improved properties as well as improved clean processing parameters.

In certain aspects the composition exhibits a surface resistivity less than $8.5 \times 10^9$ ohms, or less than $8.0 \times 10^9$ ohms, or less than $7.5 \times 10^9$ ohms, or less than $7.0 \times 10^9$ ohms, or less than $6.5 \times 10^9$ ohms, or less than $6.0 \times 10^9$ ohms, or less than $5.5 \times 10^9$ ohms, or less than $5.0 \times 10^9$ ohms, or less than $4.5 \times 10^9$ ohms, or less than $4.0 \times 10^9$ ohms, or less than $3.5 \times 10^9$ ohms, or less than $3.0 \times 10^9$ ohms, or less than $2.5 \times 10^9$ ohms, or less than $2.0 \times 10^9$ ohms, or less than $1.5 \times 10^9$ ohms, or less than $1.0 \times 10^9$ ohms, when tested in accordance with ANSI/ESD STM 11.13. In a specific aspect the composition exhibits a surface resistivity less than $2.0 \times 10^9$ ohms when tested in accordance with ANSI/ESD STM 11.13.

In particular aspects, a sample of the composition may exhibit a notched Izod impact strength greater than 150 J/m when tested in accordance with ASTM D256 at 23 °C.

## *Polypropylene Polymer*

A polypropylene polymer may refer to a polymer in which the content of the propylene unit as a constituent unit thereof is 90 wt % or more. The polypropylene polymer may have a propylene unit content of 90 to 100 wt % and may be a propylene homopolymer or a propylene-based copolymer containing, in addition to a propylene unit, an $\alpha$-olefin unit except for propylene (the "$\alpha$-olefin" as used herein encompasses ethylene) or a monomer unit except for $\alpha$-olefin, in an amount of 10 wt % or less. In some aspects, an $\alpha$-olefin unit except for propylene may include ethylene and an $\alpha$-olefin having a carbon number of 4 to 20. The $\alpha$-olefin having a carbon number of 4 to 20 includes 1-butene, 1-pentene, 1-hexene, 1-heptene, 1-octene, 1-nonene, 1-decene, 1-undecene, 1-dodecene, 1-tridecene, 1-tetradecene, 1-pentadecene, 1-hexadecene, 1-heptadecene, 1-octadecene, 1-nonadecene, 1-eicosene, 3-methyl-1-butene, 3-methyl-1-pentene, 4-methyl-1-pentene, 2-ethyl-1-hexene, 2,2,4-trimethyl-1-pentene, etc. As the $\alpha$-olefin except for propylene, ethylene and an $\alpha$-olefin having a carbon number of 4 to 10 are preferred, and ethylene, 1-butene, 1-hexene and 1-octene are more preferred.

As used herein, "polypropylene" may be used interchangeably with poly(propene). The polypropylene polymer may include a polypropylene homopolymer, a polypropylene copolymer, or a combination thereof. In some aspects the composition includes from about 65 wt% to about 90 wt% of the polypropylene polymer.

In various aspects, the polypropylene polymer may include a propylene homopolymer, a propylene-ethylene copolymer, a propylene-1-butene copolymer, a propylene-1-hexene copolymer, a propylene-1-octene copolymer, a propylene-ethylene-1-butene copolymer, a propylene-ethylene-1-hexene copolymer, and a propylene-ethylene-1-octene copolymer. A propylene homopolymer and a copolymer of propylene and at least one monomer selected from ethylene and an $\alpha$-olefin having a carbon number of 4 to 10 are preferred. The polypropylene polymer may be a polypropylene block copolymer. As an example, the polypropylene polymer may include a propylene-ethylene random copolymer such as commercially available NOVATEC™ BC3AD.

According to various aspects, the polypropylene polymer may have a propylene unit content from 90 to 100 wt %, or from 95 to 100 wt %, or preferably from 98 to 100 wt %, relative to the entire polypropylene polymer. Propylene unit content in the polypropylene polymer may be determined according to any method useful in the art, such as by infrared spectroscopy.

The polypropylene polymer may have a melt flow rate of about 0.1 g/min or more, or 10 g/10 min or more, or 20 g/10 min or more, or 30 g/10 min or more (when measured at a temperature of 230° C, and measurement load: 21.18 N).

The polypropylene polymer may have a melt flow rate less than 200 g/10 min, less than 150 g/10 min, or less than 100 g/10 min measured at a temperature of 230° C and a measurement load: 21.18 N.

Suitable commercially available polypropylene polymer may include NOVATEC™ PP of Japan Polypropylene Corporation and Pro-fax SR549M, a clarified polypropylene random copolymer resin (7% polyethylene).

In various aspects the composition includes from about 65 wt% to about 90 wt%, or from about 68 wt% to about 90 wt%, or from about 70 wt% to about 90 wt%, or from about 72 wt% to about 90 wt%, or from about 74 wt% to about 90 wt%, or from about 76 wt% to about 90 wt%, or from about 78 wt% to about 90 wt%, or from about 80 wt% to about 90 wt%, or from about 82 wt% to about 90 wt%, or from about 84 wt% to about 90 wt%, or from about 65 wt% to about 88 wt%, or from about 65 wt% to about 86 wt%, or from about 65 wt% to about 84 wt%, or from about 65 wt% to about 82 wt%, or from about 65 wt% to about 80 wt%, of the polypropylene polymer.

### Inherently Dissipative Polymer

In various aspects, the disclosed polymer compositions may include an inherently dissipative polymer (IDP). An inherently dissipative polymer may refer to a polymer resin having electrostatic dissipative (ESD) properties.

The IDP generally may include a non-functionalized polymer. includes a modified polymer. In certain aspects, the IDP may include thermoplastic elastomer, or a modified thermoplastic elastomer. Such materials are generally described as polymers having hard and/or crystalline segments and/or blocks in their backbone structure and having both soft and/or rubbery segments and/or blocks. These may be referred to as multi-block copolymer.

The IDP disclosed herein may be ion-doped. Conventionally, IDP may be sodium ion-doped. IDP of the present disclosure may be phosphonium ion-doped.

In some aspects, the inherently dissipative polymer includes a thermoplastic polyurethane (TPU), a polyolefin polyether copolymer, a thermoplastic polyester elastomer (COPE), a polyether block amide elastomer (COPA or PEBA), or a combination thereof. Examples of suitable co-polymers include polyolefin-polyether copolymers. In specific aspects, the polymer composition may include an inherently dissipative polymer IDP that is a polyether-polyolefin block copolymer or a polyether-polyolefin based multi-block copolymer. The IDP may include repeating units of propylene and ethylene oxide. In certain aspects, the IDP is hydrophobic. One such IDP may be commercially available PELECTRON™ PVL, which may be characterized as a polymer-alloy type permanent antistatic agent for polyolefin. Conventionally, where an antistatic agent such as PELECTRON PVL is used, the material may provide an antistatic property to a polyolefin, polyethylene, and polypropylene, when used in amounts of about 5 wt.% and 20 wt.% based on the total weight of the composition. Here, sample compositions of the present disclosure may include greater than 15 wt. % of PELECTRON™ PVL.

The IDP may have a surface resistivity of less than $5.0 \times 10^6$ S2, less than $4.5 \times 10^6$ S2, less than $4.0 \times 10^6$ Ω when measured in accordance with ANSI/ESD STM 11.13 on a 68 mm × 68 mm × 3 mm plaque specimen. As an example, the IDP may have a surface resistivity of about $3 \times 10^6$ Ω.

In some aspects, the polymer composition may include from about 8 wt% to about 35 wt% of an IDP. Within this range, the IDP may be present in an amount of from about 10 wt% to about 35 wt%, or from about 12 wt% to about 35 wt%, or from about 14 wt% to about 35 wt%, or from about 16 wt% to about 35 wt%, or from about 18 wt% to about 35 wt%, or from about 20 wt% to about 35 wt%, or from about 22 wt% to about 35 wt%, or from about 24 wt% to about 35 wt%, or from about 8 wt% to about 33 wt%, or from about 8 wt% to about 31 wt%, or from about 8 wt% to about 29 wt%, or from about 8 wt% to about 27 wt%, or from about 8 wt% to about 25 wt%, or from about 8 wt% to about 23 wt%, or from about 8 wt% to about 21 wt%, or from about 8 wt% to about 19 wt%, or from about 8 wt% to about 17 wt%, or from about 8 wt% to about 15 wt%, or from about 15 wt% to about 20 wt%, based on the total weight of the composition.

### Additives

The composition can include various additives ordinarily incorporated into polymer compositions of this type, with the proviso that the additive(s) are selected so as to not significantly adversely affect the desired properties of the thermoplastic composition (good compatibility for example). Such additives can be mixed at a suitable time during the mixing of the components for forming the composition. The total amount of all of the additives in the resin composition can be, for example, 0.001 to 12 wt% each based on the total weight of the composition. Suitable additives can include ultraviolet agents, ultraviolet stabilizers, heat stabilizers, antistatic agents, anti-microbial agents, anti-drip agents, radiation stabilizers, pigments, dyes, fibers, fillers, plasticizers, fibers, flame retardants, antioxidants, lubricants, wood, glass, and metals, and combinations thereof.

The composition disclosed herein can include one or more additional fillers. The filler can be selected to impart additional impact strength and/or provide additional characteristics that can be based on the final selected characteristics of the polymer composition. In certain aspects, the composite may include a glass fiber filler. In yet further aspects, the composition may be free or substantially free of a glass filler.

Additional appropriate fillers or reinforcing agents can include, for example, mica, clay, feldspar, quartz, quartzite, perlite, tripoli, diatomaceous earth, aluminum silicate (mullite), synthetic calcium silicate, fused silica, fumed silica, sand, boron-nitride powder, boron-silicate powder, calcium sulfate, calcium carbonates (such as chalk, limestone, marble, and synthetic precipitated calcium carbonates) talc (including fibrous, modular, needle shaped, and lamellar talc), wollastonite, hollow or solid glass spheres, silicate spheres, cenospheres, aluminosilicate or (armospheres), kaolin, whiskers of silicon carbide, alumina, boron carbide, iron, nickel, or copper, continuous and chopped carbon fibers or glass fibers, molybdenum sulfide, zinc sulfide, barium titanate, barium ferrite, barium sulfate, heavy spar, titanium dioxide, aluminum oxide, magnesium oxide, particulate or fibrous aluminum, bronze, zinc, copper, or nickel, glass flakes, flaked silicon carbide, flaked aluminum diboride, flaked aluminum, steel flakes, natural fillers such as wood flour, fibrous cellulose, cotton, sisal, jute, starch , lignin, ground nut shells, or rice grain husks, reinforcing organic fibrous fillers such as poly(ether ketone), polyimide, polybenzoxazole, poly(phenylene sulfide), polyesters, polyethylene, aromatic polyamides, aromatic polyimides, polyetherimides, polytetrafluoroethylene, and poly(vinyl alcohol), as well combinations including at least one of the foregoing fillers or reinforcing agents. The fillers and reinforcing agents can be coated, or surface treated, with silanes for example, to improve adhesion and dispersion with the polymer matrix.

The additive composition may include a reinforcing agent, antioxidant, heat stabilizer, light stabilizer, ultraviolet light stabilizer, ultraviolet absorbing additive, plasticizer, lubricant, release agent, antistatic agent, anti-fog agent, antimicrobial agent, chain extender, colorant, de-molding agents, surface effect additive, radiation stabilizer, flame retardant, anti-drip agent, or any combination thereof.

Heat stabilizer additives include organophosphites (e.g. triphenyl phosphite, tris-(2,6-dimethylphenyl)phosphite, tris-(mixed mono-and di-nonylphenyl)phosphite or the like), phosphonates (e.g., dimethylbenzene phosphonate or the like), phosphates (e.g., trimethyl phosphate, or the like), or combinations including at least one of the foregoing heat stabilizers. The heat stabilizer can be tris(2,4-di-t-butylphenyl) phosphate available as IRGAPHOS™ 168.

There is considerable overlap among plasticizers, lubricants, and mold release agents, which include, for example, glycerol tristearate (GTS), phthalic acid esters (e.g., octyl-4,5-epoxy-hexahydrophthalate), tris-(octoxycarbonylethyl)isocyanurate, tristearin, di- or polyfunctional aromatic phosphates (e.g., resorcinol tetraphenyl diphosphate (RDP), the bis(diphenyl) phosphate of hydroquinone and the bis(diphenyl) phosphate of bisphenol A); poly-alpha-olefins; epoxidized soybean oil; silicones, including silicone oils (e.g., poly(dimethyl diphenyl siloxanes); esters, for example, fatty acid esters (e.g., alkyl stearyl esters, such as, methyl stearate, stearyl stearate, and the like), waxes (e.g., beeswax, montan wax, paraffin wax, or the like), or combinations including at least one of the foregoing plasticizers, lubricants, and mold release agents.

Light stabilizers, in particular ultraviolet light (UV) absorbing additives, also referred to as UV stabilizers, include hydroxybenzophenones (e.g., 2-hydroxy-4-n-octoxy benzophenone), hydroxybenzotriazines, cyanoacrylates, oxanilides, benzoxazinones (e.g., 2,2'-(1,4- phenylene)bis(4H-3,1-benzoxazin-4-one, commercially available under the trade name CYASORB™ UV-3638 from Cytec Industries Inc., Woodland, NJ), aryl salicylates, hydroxybenzotriazoles (e.g., 2-(2-hydroxy-5-methylphenyl)benzotriazole, 2-(2-hydroxy-5-tert-octylphenyl)benzotriazole, and 2-(2H-benzotriazol-2-yl)-4-(1,1,3,3-tetramethylbutyl)-phenol, commercially available under the trade name CYASORB™ 5411 from Cytec Industries Inc., Woodland, NJ) or combinations including at least one of the foregoing light stabilizers.

Antioxidant additives include organophosphites such as tris(nonyl phenyl)phosphite, tris(2,4-di-t-butylphenyl) phosphite, bis(2,4-di-t-butylphenyl)pentaerythritol diphosphite, distearyl pentaerythritol diphosphite; alkylated monophenols or polyphenols; alkylated reaction products of polyphenols with dienes, such as tetrakis[methylene(3,5-di-tert-butyl-4-hydroxyhydrocinnamate)] methane; butylated reaction products of para-cresol or dicyclopentadiene; alkylated hydroquinones; hydroxylated thiodiphenyl ethers; alkylidene-bisphenols; benzyl compounds; esters of beta-(3,5-di-tert-butyl-4-hydroxyphenyl)-propionic acid with monohydric or polyhydric alcohols; esters of beta-(5-tert-butyl-4-hydroxy-3-methylphenyl)-propionic acid with monohydric or polyhydric alcohols; esters of thioalkyl or thioaryl compounds such as distearylthiopropionate, dilaurylthiopropionate, ditridecylthiodipropionate, octadecyl-3-(3,5-di-tert-butyl-4-hydroxyphenyl)propionate, pentaerythrityl-tetrakis[3-(3,5-di-tert-butyl-4-hydroxyphenyl)propionate; amides of beta-(3,5-di-tert-butyl-4-hydroxyphenyl)-propionic acid, or combinations including at least one of the foregoing antioxidants.

In certain aspects the composition includes from about 0.01 wt% to about 0.5 wt% of an antioxidant. In further aspects the composition includes from about 0.02 wt% to about 0.5 wt%, or from about 0.03 to about 0.5 wt%, or from about 0.04 wt% to about 0.5 wt%, or from about 0.05 wt% to about 0.5 wt%, or from about 0.06 wt% to about 0.5 wt%, or from about 0.07 wt% to about 0.5 wt%, or from about 0.08 wt% to about 0.5 wt%, or from about 0.09 wt% to about 0.5 wt%, or from about 0.1 wt% to about 0.5 wt%, or from about 0.01 to about 0.4 wt%, or from about 0.01 to about 0.3 wt%, or from about 0.01 to about 0.2 wt%, or from about 0.01 to about 0.1 wt%, of an antioxidant.

Useful flame retardants include organic compounds that include phosphorus, bromine, and/or chlorine. Non-brominated and non-chlorinated phosphorus-containing flame retardants can be preferred in certain applications for regulatory reasons, for example organic phosphates and organic compounds containing phosphorus-nitrogen bonds.

Anti-drip agents can also be used in the composition, for example a fibril forming or non-fibril forming fluoropolymer such as polytetrafluoroethylene (PTFE). The anti-drip agent can be encapsulated by a rigid copolymer, for example styrene-acrylonitrile copolymer (SAN). PTFE encapsulated in SAN is known as TSAN. A TSAN includes 50 wt% PTFE and 50 wt% SAN, based on the total weight of the encapsulated fluoropolymer. The SAN can include, for example, 75 wt% styrene and 25 wt% acrylonitrile based on the total weight of the copolymer.

The compositions may be formed by techniques known to those skilled in the art. Extrusion and mixing techniques, for example, may be utilized to combine the components of the resin composition.

The resin compositions of the present disclosure can be blended with the aforementioned ingredients by a variety of methods involving intimate admixing of the materials with any additional additives desired in the formulation. Because of the availability of melt blending equipment in commercial polymer processing facilities, melt processing methods are generally preferred. Illustrative examples of equipment used in such melt processing methods include co-rotating and counter-rotating extruders, single screw extruders, co-kneaders, disc-pack processors and various other types of extrusion equipment. The temperature of the melt in the present process is preferably minimized in order to avoid excessive degradation of the resins. It is often desirable to maintain the melt temperature between about 230 °C and about 350 °C in the molten resin composition, although higher temperatures can be used provided that the residence time of the resin in the processing equipment is kept short. In some aspects, the melt processed composition exits processing equipment such as an extruder through small exit holes in a die. The resulting strands of molten resin are cooled by passing the strands through a water bath. The cooled strands can be chopped into small pellets for packaging and further handling.

Compositions may be manufactured by various methods, including batch or continuous techniques that employ kneaders, extruders, mixers, and the like. For example, the composition can be formed as a melt blend employing a twin-screw extruder. In some aspects, at least some of the components are added sequentially. For example, the poly(arylene ether) component, the polystyrene component(s), and the impact modifier component can be added to the extruder at the feed throat or in feeding sections adjacent to the feed throat, or in feeding sections adjacent to the feed throat, while the filler component can be added to the extruder in a subsequent feeding section downstream. Alternatively, the sequential addition of the components may be accomplished through multiple extrusions. A composition may be made by preextrusion of selected components, such as the poly(arylene ether) component, the polystyrene component(s), and the impact modifier component to produce a pelletized mixture. A second extrusion can then be employed to combine the preextruded components with the remaining components. The filler component can be added as part of a masterbatch or directly. The extruder can be a two lobe or three lobe twin screw extruder. According to various aspects, the disclosed compositions may be prepared by compounding on a twin-screw extruder. Materials may be blended together and fed by the main feeder. Extruded strands of the composition may be processed into pellets and dried for further molding and evaluation. The testing was conducted on pellets and molded parts.

In one aspect, the present disclosure pertains to plastic components, for example, that have been shaped, formed, or molded at least in part from the compositions described herein. Also provided are plastic components including a resin composition that is formed according to the presently disclosed methods for forming a resin composition.

## Methods of Manufacture

Aspects of the disclosure further relate to methods for making a thermoplastic composition. The one or any foregoing components described herein may be first dry blended with each other, or dry blended with any combination of foregoing components, then fed into an extruder from one or multi-feeders, or separately fed into an extruder from one or multi-feeders. The fillers used in the disclosure may also be first processed into a masterbatch, then fed into an extruder. The components may be fed into the extruder from a throat hopper or any side feeders.

The extruders used in the disclosure may have a single screw, multiple screws, intermeshing co-rotating or counter rotating screws, non-intermeshing co-rotating or counter rotating screws, reciprocating screws, screws with pins, screws with screens, barrels with pins, rolls, rams, helical rotors, co-kneaders, disc-pack processors, various other types of extrusion equipment, or combinations including at least one of the foregoing.

The components may also be mixed together and then melt-blended to form the thermoplastic compositions. The melt blending of the components involves the use of shear force, extensional force, compressive force, ultrasonic energy, electromagnetic energy, thermal energy or combinations including at least one of the foregoing forces or forms of energy. The barrel temperature on the extruder during compounding can be set at the temperature where at least a portion of the polymer has reached a temperature greater than or equal to about the melting temperature, if the resin is a semi-crystalline organic polymer, or the flow point (for example, the glass transition temperature) if the resin is an amorphous resin.

The mixture including the foregoing mentioned components may be subject to multiple blending and forming steps if desirable. For example, the thermoplastic composition may first be extruded and formed into pellets. The pellets may then be fed into a molding machine where it may be formed into any desirable shape or product. Alternatively, the thermoplastic composition emanating from a single melt blender may be formed into sheets or strands and subjected to post-extrusion processes such as annealing, uniaxial or biaxial orientation.

The temperature of the melt in the present process may in some aspects be maintained as low as possible in order to avoid excessive thermal degradation of the components. In certain aspects the melt temperature is maintained between about 230°C and about 350°C, although higher temperatures can be used provided that the residence time of the resin in the processing equipment is kept relatively short. In some aspects, the melt processed composition exits processing equipment such as an extruder through small exit holes in a die. The resulting strands of molten resin may be cooled by passing the strands through a water bath. The cooled strands can be chopped into pellets for packaging and further handling.

In certain aspects, the blends may be processed using a clean compound solution where the materials are compounded in deionized water.

Methods may further include processing the composite to provide a plaque of a desired thickness. Plaques can be extruded, injection molded, compression molded, or injection-compression molded, and may have a thickness between about 0.4 mm and 6 mm. Other processes could also be applied to the thin thermoplastic film, including but not limited to, lamination, co-extrusion, thermo-forming or hot pressing. In such aspects, further layers of other materials (for example, other thermoplastic polymer layers, metallic layers, etc.) could be combined with the composite.

### *Properties and Articles*

Classical ESD materials are generally not colorable as they are limited by the conductive carbon fillers' natural black color or darkness. Conversely, those compounds doped with conventional inherently dissipative polymers (IDP) (in order to achieve electrostatic behavior) cannot reach surface resistivity as low as $1 \times 10^9$ Ohms notwithstanding their colorless appearance. The disclosed compositions are a combination of specific IDP and polypropylene formed under a clean environment and may provide high impact performance, colorability, and clean ESD materials. The disclosed combination of polypropylene-based IDP, polypropylene, and an optional antioxidant provides desirable ESD properties while maintaining a broad color space and sufficient impact strength. The disclosed compositions also adhere to certain clean processing parameters.

Compositions of the present disclosure may exhibit a sufficiently low surface resistivity so as to exhibit ESD performance. These compositions may exhibit a surface resistivity of less than $9 \times 10^9$ ohms when tested in accordance with ANSI/ESD STM 11.13. The compositions further exhibit a sufficiently high impact strength and toughness. For example, the compositions may exhibit a notched Izod impact strength greater than 150 J/m when tested in accordance with ASTM D256 at 23 °C.

In various aspects, the disclosed compositions exhibit improved performance with respect to certain clean processing parameters. For example, the compositions may exhibit a lower amount of leachable ions or species present under normal product, application, and/or storage conditions. In specific aspects, the compositions may exhibit a leachable ion content less than 20 parts per million when tested via ion chromatography on samples in 80 °C deionized water for one hour. Furthermore, the compositions may exhibit a total outgassing less than 80 parts per million when measured by dynamic headspace gas chromatography-mass spectrometry under at a temperature of 85 °C for three hours.

As provided herein, compositions of the present disclosure are colorable. Colorable may describe the ease of coloring of the polymer composition. That is, the polymer composition may be sufficiently "light" in color to accept dyes, pigments, or other color treatments/additives that impart a desired hue to the composition. Conventional dissipative materials often include dissipative additives that are dark in color such as carbon fiber or carbon black. As such the color space for conventional ESD materials may be limited. The disclosed compositions may alleviate these restrictions as they achieve surface resistivities less than $9 \times 10^9$ Ohms when tested in accordance with ANSI/ESD STM 11.13, while also being colorable. Values of the present disclosure have certain values for certain colorimetric coordinates L\*, a\*, b\*. The "L\* value" describes the lightness-darkness property. If the L\* value is 0, the object is black. If the L\* value is 100 the object is white. The L\* value is always positive. Compositions having an L\* value further away from the extremes (0 and 100) have a more natural color, which may be the selected color for a specific application or which may enable the composition to be more easily colored. Having values further away from 0 and closer to 100 for L\* results in a composition that has a much wider "color space". The "color space" is the range of L\* that can be achieved using an optional colorant, pigment and/or dye. L\* may be measured using ASTM 2244 With 10 degree observer; International Commission on Illumination (CIE) Standard Illuminant D65 illuminant; specular component included (SCI) reflectance; and large aperture). The disclosed composition may exhibit an L\* color value of at least about 70, or at least about 75, or at least about 80 or at least about 90 when measured using a spectrophotometer with D65 illumination in a 10° observer in reflection mode.

These compositions are thus suitable candidates for consumer electronics/semi-conductor/construction applications and enable a critical capability to be made into ESD products with customized color. Furthermore, these compositions demonstrate the potential to replace traditional carbon fiber, conductive carbon black, graphite, graphene, carbon nano tube, etc., filled ESD materials in the market.

The advantageous characteristics of the compositions disclosed herein make them appropriate for an array of uses. In various aspects, the disclosed compositions may be useful for semi-conductor/electronic handling applications.

Various combinations of elements of this disclosure are encompassed by this disclosure, for example, combinations of elements from dependent claims that depend upon the same independent claim.

**Definitions**

It is also to be understood that the terminology used herein is for the purpose of describing particular aspects only and is not intended to be limiting. As used in the specification and in the claims, the term "comprising" can include the aspects "consisting of" and "consisting essentially of." Unless defined otherwise, all technical and scientific terms used herein have the same meaning as commonly understood by one of ordinary skill in the art to which this disclosure belongs. In this specification and in the claims, which follow, reference will be made to a number of terms which shall be defined herein.

As used in the specification and the appended claims, the singular forms "a," "an" and "the" include plural referents unless the context clearly dictates otherwise. Thus, for example, reference to "a thermoplastic polymer component" includes mixtures of two or more thermoplastic polymer components. As used herein, the term "combination" is inclusive of blends, mixtures, alloys, reaction products, and the like.

Ranges can be expressed herein as from one value (first value) to another value (second value). When such a range is expressed, the range includes in some aspects one or both of the first value and the second value. Similarly, when values are expressed as approximations, by use of the antecedent 'about,' it will be understood that the particular value forms another aspect. It will be further understood that the endpoints of each of the ranges are significant both in relation to the other endpoint, and independently of the other endpoint. It is also understood that there are a number of values disclosed herein, and that each value is also herein disclosed as "about" that particular value in addition to the value itself. For example, if the value "10" is disclosed, then "about 10" is also disclosed. It is also understood that each unit between two particular units are also disclosed. For example, if 10 and 15 are disclosed, then 11, 12, 13, and 14 are also disclosed.

As used herein, the terms "about" and "at or about" mean that the amount or value in question can be the designated value, approximately the designated value, or about the same as the designated value. It is generally understood, as used herein, that it is the nominal value indicated $\pm 10\%$ variation unless otherwise indicated or inferred. The term is intended to convey that similar values promote equivalent results or effects recited in the claims. That is, it is understood that amounts, sizes, formulations, parameters, and other quantities and characteristics are not and need not be exact, but can be approximate and/or larger or smaller, as desired, reflecting tolerances, conversion factors, rounding off, measurement error and the like, and other factors known to those of skill in the art. In general, an amount, size, formulation, parameter or other quantity or characteristic is "about" or "approximate" whether or not expressly stated to be such. It is understood that where "about" is used before a quantitative value, the parameter also includes the specific quantitative value itself, unless specifically stated otherwise.

As used herein, the terms "optional" or "optionally" means that the subsequently described event or circumstance can or cannot occur, and that the description includes instances where said event or circumstance occurs and instances where it does not. For example, the phrase "optional additional processes" means that the additional processes can or cannot be included and that the description includes methods that both include and that do not include the additional processes.

Disclosed are the components to be used to prepare the compositions of the disclosure as well as the compositions themselves to be used within the methods disclosed herein. These and other materials are disclosed herein, and it is understood that when combinations, subsets, interactions, groups, etc. of these materials are disclosed that while specific reference of each various individual and collective combinations and permutation of these compounds cannot be explicitly disclosed, each is specifically contemplated and described herein. For example, if a particular compound is disclosed and discussed and a number of modifications that can be made to a number of molecules including the compounds are discussed, specifically contemplated is each and every combination and permutation of the compound and the modifications that are possible unless specifically indicated to the contrary. Thus, if a class of molecules A, B, and C are disclosed as well as a class of molecules D, E, and F and an example of a combination molecule, A-D is disclosed, then even if each is not individually recited each is individually and collectively contemplated meaning combinations, A-E, A-F, B-D, B-E, B-F, C-D, C-E, and C-F are considered disclosed. Likewise, any subset or combination of these is also disclosed. Thus, for example, the sub-group of A-E, B-F, and C-E would be considered disclosed. This concept applies to all aspects of this application including, but not limited to, steps in methods of making and using the compositions of the disclosure. Thus, if there are a variety of additional steps that can be performed it is understood that each of these additional steps can be performed with any specific aspect or combination of aspects of the methods of the disclosure.

References in the specification and concluding aspects to parts by weight of a particular element or component in a composition or article, denotes the weight relationship between the element or component and any other elements or components in the composition or article for which a part by weight is expressed. Thus, in a compound containing 2 parts by weight of component X and 5 parts by weight component Y, X and Y are present at a weight ratio of 2:5, and are present in such ratio regardless of whether additional components are contained in the compound.

A weight percent of a component, unless specifically stated to the contrary, is based on the total weight of the formulation or composition in which the component is included.

The terms "residues" and "structural units", used in reference to the constituents of the polymers, are synonymous throughout the specification.

As used herein the terms "weight percent," "wt%," and "wt. %," which can be used interchangeably, indicate the percent by weight of a given component based on the total weight of the composition, unless otherwise specified. That is, unless otherwise specified, all wt% values are based on the total weight of the composition. It should be understood that the sum of wt% values for all components in a disclosed composition or formulation is 100.

Unless otherwise stated to the contrary herein, all test standards are the most recent standard in effect at the time of filing this application.

As used herein, the terms "number average molecular weight" or "$M_n$" can be used interchangeably, and refer to the statistical average molecular weight of all the polymer chains in the sample and is defined by the formula:

$$M_n = \frac{\sum N_i M_i}{\sum N_i},$$

where $M_i$ is the molecular weight of a chain and $N_i$ is the number of chains of that molecular weight. $M_n$ can be determined for polymers, for example, polycarbonate polymers, by methods well known to a person having ordinary skill in the art using molecular weight standards, e.g., polycarbonate standards or polystyrene standards, preferably certified or traceable molecular weight standards.

As used herein, the terms "weight average molecular weight" or "$M_w$" can be used interchangeably, and are defined by the formula:

$$M_w = \frac{\sum N_i M_i{}^2}{\sum N_i M_i},$$

where $M_i$ is the molecular weight of a chain and $N_i$ is the number of chains of that molecular weight. Compared to $M_n$, $M_w$ takes into account the molecular weight of a given chain in determining contributions to the molecular weight average. Thus, the greater the molecular weight of a given chain, the more the chain contributes to the $M_w$. $M_w$ can be determined for polymers, for example, polycarbonate polymers, by methods well known to a person having ordinary skill in the art using molecular weight standards, for example, polycarbonate standards or polystyrene standards, preferably certified or traceable molecular weight standards.

As used herein, degree of polymerization, n, may describe the number of monomeric units (or repeating units) in a given polymer molecule.

References in the specification and concluding claims to parts by weight of a particular element or component in a composition or article, denotes the weight relationship between the element or component and any other elements or components in the composition or article for which a part by weight is expressed. Thus, in a compound containing 2 parts by weight of component X and 5 parts by weight component Y, X and Y are present at a weight ratio of 2:5, and are present in such ratio regardless of whether additional components are contained in the compound.

In one aspect, "substantially free of" can be less than about 0.5 weight percent (wt%). In another aspect, substantially free of can be less than about 0.1 wt%. In another aspect, substantially free of can be less than about 0.01 wt%. In yet another aspect, substantially free of can be less than about 100 ppm. In yet another aspect, substantially free can refer to an amount, if present at all, below a detectable level. In one aspect, the compositions of the present disclosure are free of or substantially free of carbon filler or carbon-based filler. In certain aspects, to maintain colorability of the disclosed compositions, the compositions may be free of or substantially free of carbon black, carbon fiber, and/or graphite. In some examples, carbon black may be present in an amount sufficient for coloring rather than to impart conductive properties. For example, carbon black may be present in an amount less than 1 wt%, less than 0.5 wt% or less than 0.3 wt% based on the total weight of the composition.

Each of the materials disclosed herein are either commercially available and/or the methods for the production thereof are known to those of skill in the art.

It is understood that the compositions disclosed herein have certain functions. Disclosed herein are certain structural requirements for performing the disclosed functions and it is understood that there are a variety of structures that can perform the same function that are related to the disclosed structures, and that these structures will typically achieve the same result.

# EP 4 578 911 A1

## Aspects of the Disclosure

In various aspects, the present disclosure pertains to and includes at least the following aspects.

Aspect 1. A composition comprising:

from about 65 wt% to about 90 wt% of a polypropylene resin; and
from about 8 wt% to about 35 wt% of an inherently dissipative polymer (IDP), wherein the IDP comprises a polyether-polyolefin block copolymer,
wherein the combined weight percent value of all components does not exceed 100 wt %, all weight percent values are based on the total weight of the composition, and
wherein the composition exhibits a surface resistivity less than $9.0 \times 10^9 \, \Omega$ when tested in accordance with ANSI/ESD STM 11.13.

Aspect 2. The composition according to Aspect 1, wherein the IDP is a non-functionalized polymer.

Aspect 3. The composition according to any one of Aspects 1-2, wherein the polypropylene resin comprises a polypropylene homopolymer.

Aspect 4. The composition according to any one of Aspects 1-2, wherein the polypropylene resin comprises a polypropylene copolymer.

Aspect 5. The composition according to any one of Aspects 1-4, wherein the IDP comprises a polypropylene-polyether olefin copolymer.

Aspect 6. The composition according to any one of Aspects 1-5, wherein the IDP is a hydrophobic polymer.

Aspect 7. The composition according to any one of Aspects 1-6, wherein the composition further comprises an antioxidant in an amount from about 0.01 wt% to 0.5 wt%.

Aspect 8. The composition according to any one of Aspects 1-7, wherein the IDP is present in an amount from 15 wt% to 20 wt%.

Aspect 9. The composition according to any one of Aspects 1-8, wherein the inherently dissipative polymer has a surface resistivity less than $4.0 \times 10^6 \, \Omega$ when measured in accordance with ANSI/ESD STM 11.13.

Aspect 10. The composition according to any one of Aspects 1-9, wherein the composition exhibits a notched Izod impact strength greater than 150 J/m when tested in accordance with ASTM D256 at 23 °C.

Aspect 11. The composition of according to any one of Aspects 1-10, wherein the composition exhibits an L* color coordinate value of at least 70 when measured using a spectrophotometer with D65 illumination in a 10° observer in reflection mode at 23 °C.

Aspect 12. The composition according to any one of Aspects 1-11, wherein the composition exhibits a leachable ion content less than 20 parts per million when tested via ion chromatography on samples in 80 °C deionized water for one hour.

Aspect 13. The composition of according to any one of Aspects 1-12, wherein the composition exhibits a total outgassing less than 80 parts per million when measured by dynamic headspace gas chromatography-mass spectrometry at a temperature of 85 °C for three hours.

Aspect 14. The composition according to any one of Aspects 1-13, wherein the composition is free of or substantially free of carbon black.

Aspect 15. The composition according to any one of Aspects 1-14, wherein the composition is free of or substantially free of carbon fiber.

Aspect 16. The composition according to any one of Aspects 1-15, wherein the composition is free of or substantially free of graphite, carbon nanotubes, or graphene.

Aspect 17. The composition according to any one of Aspects 1-16, further comprising an additive material, the additive material selected from the group consisting of: a metal deactivator; an acid scavenger; an antioxidant; a colorant; a dye; a flow promoter; a flow modifier; an impact modifier; a lubricant; a mold release agent; a pigment; a colorant, a quenching agent; a thermal stabilizer; an ultraviolet (UV) absorbent; a UV reflectant; a UV stabilizer; a flame retardant; and combinations thereof.

Aspect 18. The composition according to any one of Aspects 1-17, wherein the composition exhibits a surface resistivity less than $2.0 \times 109 \, \Omega$ when tested in accordance with ANSI/ESD STM 11.13.

Aspect 19. An article formed from the composition of any one of Aspects 1-18.

Aspect 20. The article according to Aspect 19, wherein the article is a semiconductor wafer carrier.

Aspect 21. A method of forming a composition, the method comprising:

(a) combining, to form a resin mixture,

i. from about 65 wt% to about 90 wt% of a polypropylene resin,

ii. from about 8 wt% to about 35 wt% of an inherently dissipative polymer (IDP), wherein the IDP comprises a polyether olefin based polymer,
iii. optionally from about 0.01 wt% to about 0.5 wt% of an antioxidant;

(b) adding deionized water to the resin mixture to form an aqueous resin mixture; and

(c) extruding the aqueous resin mixture to form the composition,

wherein the combined weight percent value of all components does not exceed 100 wt %, and all weight percent values are based on the total weight of the composition, and
wherein the composition exhibits a surface resistivity less than $9.0 \times 10^9 \, \Omega$ when tested in accordance with ANSI/ESD STM 11.13.

**EXAMPLES**

The following examples are put forth so as to provide those of ordinary skill in the art with a complete disclosure and description of how the compounds, compositions, articles, devices and/or methods claimed herein are made and evaluated and are intended to be purely exemplary and are not intended to limit the disclosure. Efforts have been made to ensure accuracy with respect to numbers (for example, amounts, temperature, etc.), but some errors and deviations should be accounted for. Unless indicated otherwise, parts are parts by weight, temperature is in °C or is at ambient temperature, and pressure is at or near atmospheric. Unless indicated otherwise, percentages referring to composition are in terms of wt%.

There are numerous variations and combinations of mixing conditions, for example, component concentrations, extruder design, feed rates, screw speeds, temperatures, pressures and other mixing ranges and conditions that can be used to optimize the product purity and yield obtained from the described process. Only reasonable and routine experimentation will be required to optimize such process conditions.

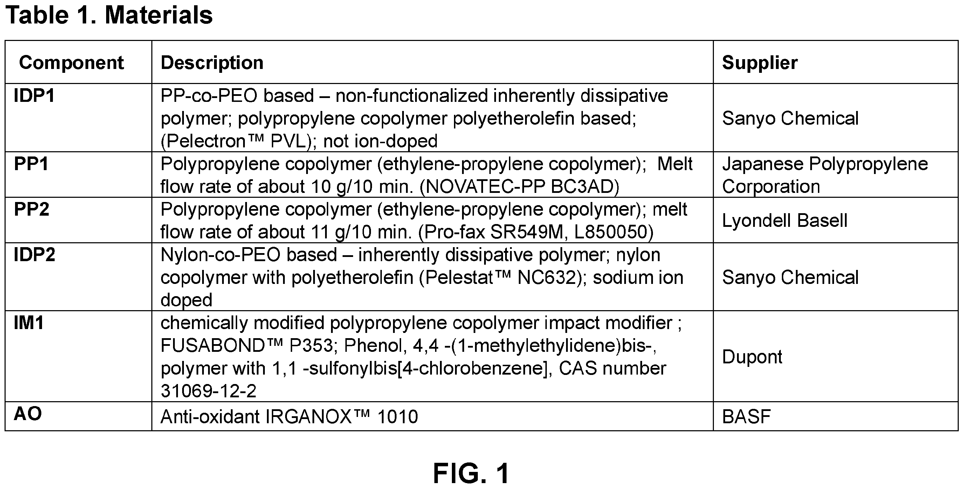

Various compositions were prepared by compounding on a 37 mm twin screw extruder from the raw materials shown in Table 1 (FIG. 1).

All materials were blended together and fed by the main feeder. Strands including the composition were cut into pellets and dried for further molding and evaluation. All testing was conducted on pellets and molded parts. Compounding was performed on a Coperion W&P ZSK26Mc instrument, and the profiles are shown in Table 2.

**Table 2.** Temperature profiles for compounding

|  | Output (kg/hr) | Screw (RPM) | Vacuum (MPa) | Torque (%) | Barrel temp.°C | Die temp.°C |
|---|---|---|---|---|---|---|
| Setting condition | 70 | 200 | -0.1 | 30 | 180 | 180 |

Injection molding conditions are shown in Table 3. Injection was performed on Fanuc S-2000i with ASTM-family tool.

**Table 3.** Specimen injection molding profile.

| Molding parameters | unit | Value |
|---|---|---|
| Pre-drying time | Hour | 4 |
| Pre-drying temp | °C | 80 |
| Hopper temp | °C | 70 |
| Zone 1 temp | °C | 170-180 |
| Zone 2 temp | °C | 170-180 |
| Zone 3 temp | °C | 170-180 |
| Nozzle temp | °C | 170-180 |
| Mold temp | °C | 50 |

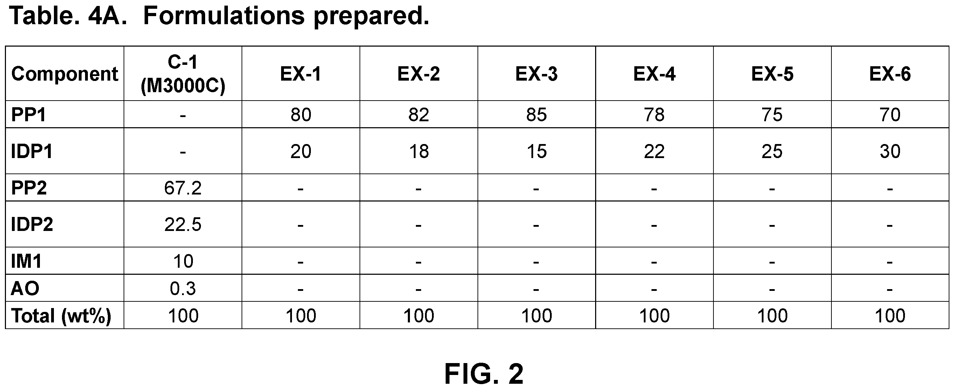

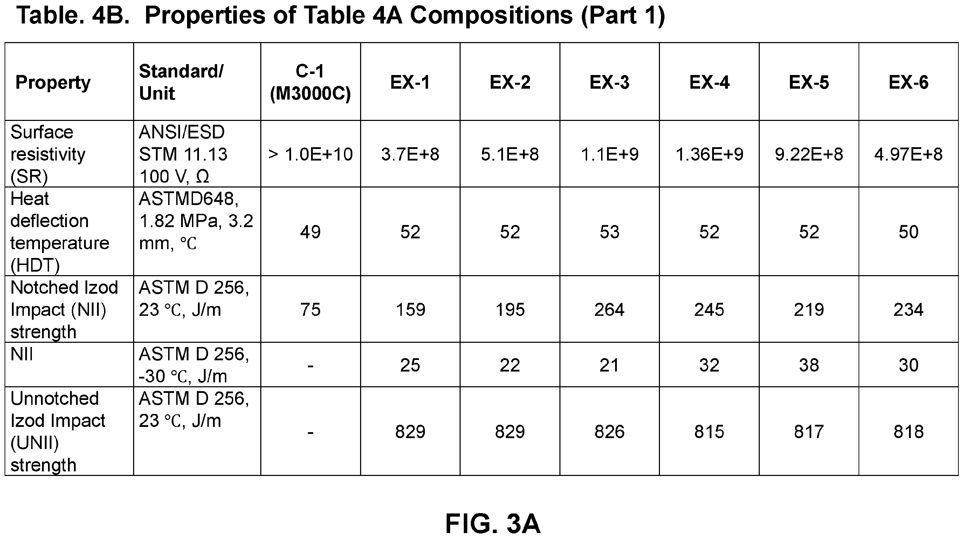

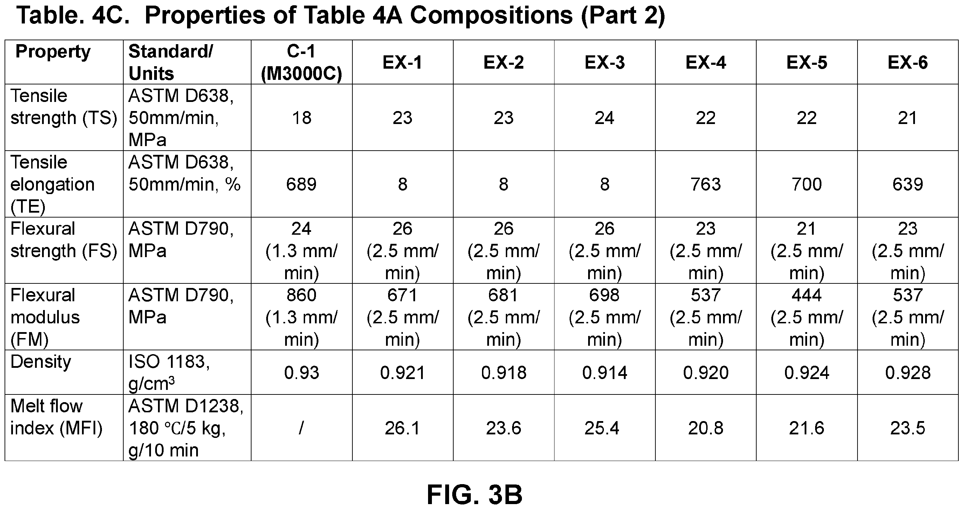

Formulations were prepared as shown in Table 4A (FIG. 2) and evaluated for the following properties shown in Table 4B (FIG. 3A) and Table 4C (FIG. 3B): surface resistivity according to ANSI/ESD STM 11.13 at 100 volts (V); heat deflection temperature (HDT) at 0.45 MPa and 1.82 MPa on 3.2 mm thick bars, according to ASTM D 648; notched Izod impact strength, according to ASTM D 256 at 23 °C and -30 °C; unnotched Izod impact strength, according to ASTM D 256 at 23 °C; tensile strength according to ASTM D638 at 50 millimeters per minute (mm/in); tensile elongation according to ASTM D638 at 50 mm/min; flexural strength according to ASTM D790; flexural modulus according to ASTM D790 at 2.5 mm/min or 1.3 mm/min; density according to ISO 1183; melt flow index according to ASTM D1238 at 180 °C per 5 kg load (180 °C/5 kg load or 180 °C and 5 kg/load); and color indices/coordinates L*, a, and b according CIE 1967. Comparative formulation C-1 combined polypropylene and nylon based IDP as well as an impact modifier and antioxidant. Examples EX-1 through EX-3 combined polypropylene polymer, polypropylene based IDP, and antioxidant.

Conventional conductive PPs are developed by incorporating conductive carbon-based fillers, such as conductive carbon black and carbon fiber resulting in compositions that were black having no further coloring space. Commercially available formulations such as comparative example C-1 (grade name: M3000C) combine PP and an inherently dissipative polymer (IDP). As the natural appearance of IDP is colorless, further coloring potential is maintained. However, conventional IDPs like IDP (Nylon-co-PEO based) as in C-1 is nylon-co-PEO based, which was not compatible with PP. The observed impact strength was very low - too low to meet standards for toughness even when combined with an impact modifier. Moreover, the surface resistivity SR of comparative example of C-1 is about1.0 E+10-12 Ω. Without wishing to be bound by any particular theory, this may be attributed to the intrinsically high SR of IDP (Nylon-co-PEO based) (which has an SR of about 1.0 E+9 S2). These values are beyond the range for a conventional ESD material which is desirably an SR of less than 1.0 E+9.

Examples EX-1 through EX-3 combined polypropylene polymer and PP-co-PEO to provide a low intrinsic SR of 3.0 E+6 Ω. A loading of 20 wt% IDP (PP-co-PEO based) as in EX-1 achieved a low SR of 6.6 E+9 S2, in compliance with stringent ESD standards (ANSI/ESD STM 11.13). Furthermore, EX-1 exhibited more than double the notched Izod impact strength (159 J/m) compared to C-1.

The formulations were also evaluated for their colorability. As shown in Table 5, the observed L* values for EX-1 through EX-3 were 78 - 80.4, demonstrating sufficient whiteness for coloring space.

Table 5. Color coordinate values for formulations.

|  | L* | a* | b* |
|---|---|---|---|
| EX-1 | 78.3 | 0.7 | 20.4 |
| EX-2 | 79.6 | 0.1 | 19.4 |
| EX-3 | 80.4 | -0.2 | 18.2 |

Adherence to clean parameters was also observed. The formulations were compounded clean processing using deionized water rinsing. The extruded pellets were sealed in aluminum packages. The leachable ion content of the formulations was measured by ion chromatography on pellets immersed in 80 °C deionized water for 1 hour. Total outgassing was measured by dynamic headspace gas chromatography-mass spectrometry, under 85 °C for 3 hours. As shown in Table 6, EX-1 to EX-3 exhibited low leachable ion content and low outgassing.

Table 6. Cleanliness data for EX-1 through EX-3

|  | Total leachable ion (ppm) | Total outgassing (ppm) |
|---|---|---|
| EX-1 | 10.8 | 72.7 |
| EX-2 | 4.9 | 54.2 |
| EX-3 | 1.7 | 68 |
| EX-4 | 10.1 | / |
| EX-5 | 17.5 | / |
| EX-6 | 36.6 | / |

Without wishing to be bound by any particular theory, the total leachable ion content of EX-6 may be higher than the other formulations EX-1 through EX-5 because EX-6 includes a lower PP content or because the PP-co-PEO based IDP content is higher (30 wt%).

The above description is intended to be illustrative, and not restrictive. For example, the above-described examples (or one or more aspects thereof) may be used in combination with each other. Other aspects can be used, such as by one of ordinary skill in the art upon reviewing the above description. The Abstract is provided to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, disclosed subject matter may lie in less than all features of a particular disclosed aspect. Thus, the following claims are hereby incorporated into the Detailed Description as examples or aspects, with each claim standing on its own as a separate aspect, and it is contemplated that such aspects can be combined with each other in various combinations or permutations. The scope of the disclosure should be determined with reference to the appended claims, along with the full scope of equivalents to which such claims are entitled.

It will be apparent to those skilled in the art that various modifications and variations can be made in the present disclosure without departing from the scope or spirit of the disclosure. Other aspects of the disclosure will be apparent to those skilled in the art from consideration of the specification and practice of the disclosure disclosed herein. It is intended that the specification and examples be considered as exemplary only, with a true scope and spirit of the disclosure being indicated by the following claims.

The patentable scope of the disclosure is defined by the claims, and can include other examples that occur to those skilled in the art. Such other examples are intended to be within the scope of the claims if they have structural elements that do not differ from the literal language of the claims, or if they include equivalent structural elements with insubstantial differences from the literal languages of the claims. It is understood that the compositions disclosed herein have certain functions. Disclosed herein are certain structural requirements for performing the disclosed functions, and it is understood that there are a variety of structures that can perform the same function that are related to the disclosed structures, and that these structures will typically achieve the same result.

**Claims**

1. A composition comprising:

   from about 65 wt% to about 90 wt% of a polypropylene resin; and
   from about 8 wt% to about 35 wt% of an inherently dissipative polymer (IDP), wherein the IDP comprises a polyether-polyolefin block copolymer,
   wherein the combined weight percent value of all components does not exceed 100 wt %, all weight percent values are based on the total weight of the composition, and
   wherein the composition exhibits a surface resistivity less than $9.0 \times 10^9\ \Omega$ when tested in accordance with ANSI/ESD STM 11.13.

2. The composition according to claim 1, wherein the IDP is a non-functionalized polymer.

3. The composition according to any one of claims 1-2, wherein the polypropylene resin comprises a polypropylene homopolymer or a polypropylene copolymer.

4. The composition according to any one of claims 1-3, wherein the IDP comprises a polypropylene-polyether olefin copolymer.

5. The composition according to any one of claims 1-4, wherein the IDP is a hydrophobic polymer.

6. The composition according to any one of claims 1-5, wherein the IDP is present in an amount from 15 wt% to 20 wt%.

7. The composition according to any one of claims 1-6, wherein the inherently dissipative polymer has a surface resistivity less than $4.0 \times 10^6\ \Omega$ when measured in accordance with ANSI/ESD STM 11.13.

8. The composition according to any one of claims 1-7, wherein:

   (a) the composition exhibits a notched Izod impact strength greater than 150 J/m when tested in accordance with ASTM D256 at 23 °C;
   (b) the composition exhibits an L* color coordinate value of at least 70 when measured using a spectrophotometer with D65 illumination in a 10° observer in reflection mode at 23 °C;
   (c) the composition exhibits a leachable ion content less than 20 parts per million when tested via ion chromatography on samples in 80 °C deionized water for one hour; or
   (d) the composition exhibits a total outgassing less than 80 parts per million when measured by dynamic headspace gas chromatography-mass spectrometry at a temperature of 85 °C for three hours.

9. The composition according to any one of claims 1-8, wherein the composition is free of or substantially free of carbon black.

10. The composition according to any one of claims 1-9, wherein the composition is free of or substantially free of carbon fiber.

11. The composition according to any one of claims 1-10, wherein the composition is free of or substantially free of graphite, carbon nanotubes, or graphene.

12. The composition according to any one of claims 1-12, wherein the composition exhibits a surface resistivity less than $2.0 \times 10^9 \, \Omega$ when tested in accordance with ANSI/ESD STM 11.13.

13. The composition according to any one of claims 1-12, further comprising an additive material, the additive material selected from the group consisting of: a metal deactivator; an acid scavenger; an antioxidant; a colorant; a dye; a flow promoter; a flow modifier; an impact modifier; a lubricant; a mold release agent; a pigment; a colorant, a quenching agent; a thermal stabilizer; an ultraviolet (UV) absorbent; a UV reflectant; a UV stabilizer; a flame retardant; and combinations thereof.

14. An article formed from the composition of any one of claims 1-13, wherein the article is a semiconductor wafer carrier.

15. A method of forming a composition, the method comprising:

   (a) combining, to form a resin mixture,

       i. from about 65 wt% to about 90 wt% of a polypropylene resin,
       ii. from about 8 wt% to about 35 wt% of an inherently dissipative polymer (IDP), wherein the IDP comprises a polyether olefin based polymer,
       iii. optionally from about 0.01 wt% to about 0.5 wt% of an antioxidant;

   (b) adding deionized water to the resin mixture to form an aqueous resin mixture; and
   (c) extruding the aqueous resin mixture to form the composition,
   wherein the combined weight percent value of all components does not exceed 100 wt %, and all weight percent values are based on the total weight of the composition, and
   wherein the composition exhibits a surface resistivity less than $9.0 \times 10^9 \, \Omega$ when tested in accordance with ANSI/ESD STM 11.13.

# Table 1. Materials

| Component | Description | Supplier |
|---|---|---|
| IDP1 | PP-co-PEO based – non-functionalized inherently dissipative polymer; polypropylene copolymer polyetherolefin based; (Pelectron™ PVL); not ion-doped | Sanyo Chemical |
| PP1 | Polypropylene copolymer (ethylene-propylene copolymer); Melt flow rate of about 10 g/10 min. (NOVATEC-PP BC3AD) | Japanese Polypropylene Corporation |
| PP2 | Polypropylene copolymer (ethylene-propylene copolymer); melt flow rate of about 11 g/10 min. (Pro-fax SR549M, L850050) | Lyondell Basell |
| IDP2 | Nylon-co-PEO based – inherently dissipative polymer; nylon copolymer with polyetherolefin (Pelestat™ NC632); sodium ion doped | Sanyo Chemical |
| IM1 | chemically modified polypropylene copolymer impact modifier ; FUSABOND™ P353; Phenol, 4,4 -(1-methylethylidene)bis-, polymer with 1,1 -sulfonylbis[4-chlorobenzene], CAS number 31069-12-2 | Dupont |
| AO | Anti-oxidant IRGANOX™ 1010 | BASF |

## FIG. 1

## Table. 4A. Formulations prepared.

| Component | C-1 (M3000C) | EX-1 | EX-2 | EX-3 | EX-4 | EX-5 | EX-6 |
|---|---|---|---|---|---|---|---|
| PP1 | - | 80 | 82 | 85 | 78 | 75 | 70 |
| IDP1 | - | 20 | 18 | 15 | 22 | 25 | 30 |
| PP2 | 67.2 | - | - | - | - | - | - |
| IDP2 | 22.5 | - | - | - | - | - | - |
| IM1 | 10 | - | - | - | - | - | - |
| AO | 0.3 | - | - | - | - | - | - |
| Total (wt%) | 100 | 100 | 100 | 100 | 100 | 100 | 100 |

**FIG. 2**

EP 4 578 911 A1

# Table. 4B. Properties of Table 4A Compositions (Part 1)

| Property | Standard/ Unit | C-1 (M3000C) | EX-1 | EX-2 | EX-3 | EX-4 | EX-5 | EX-6 |
|---|---|---|---|---|---|---|---|---|
| Surface resistivity (SR) | ANSI/ESD STM 11.13 100 V, Ω | > 1.0E+10 | 3.7E+8 | 5.1E+8 | 1.1E+9 | 1.36E+9 | 9.22E+8 | 4.97E+8 |
| Heat deflection temperature (HDT) | ASTMD648, 1.82 MPa, 3.2 mm, °C | 49 | 52 | 52 | 53 | 52 | 52 | 50 |
| Notched Izod Impact (NII) strength | ASTM D 256, 23 °C, J/m | 75 | 159 | 195 | 264 | 245 | 219 | 234 |
| NII | ASTM D 256, -30 °C, J/m | - | 25 | 22 | 21 | 32 | 38 | 30 |
| Unnotched Izod Impact (UNII) strength | ASTM D 256, 23 °C, J/m | - | 829 | 829 | 826 | 815 | 817 | 818 |

## FIG. 3A

## Table. 4C. Properties of Table 4A Compositions (Part 2)

| Property | Standard/ Units | C-1 (M3000C) | EX-1 | EX-2 | EX-3 | EX-4 | EX-5 | EX-6 |
|---|---|---|---|---|---|---|---|---|
| Tensile strength (TS) | ASTM D638, 50mm/min, MPa | 18 | 23 | 23 | 24 | 22 | 22 | 21 |
| Tensile elongation (TE) | ASTM D638, 50mm/min, % | 689 | 8 | 8 | 8 | 763 | 700 | 639 |
| Flexural strength (FS) | ASTM D790, MPa | 24 (1.3 mm/ min) | 26 (2.5 mm/ min) | 26 (2.5 mm/ min) | 26 (2.5 mm/ min) | 23 (2.5 mm/ min) | 21 (2.5 mm/ min) | 23 (2.5 mm/ min) |
| Flexural modulus (FM) | ASTM D790, MPa | 860 (1.3 mm/ min) | 671 (2.5 mm/ min) | 681 (2.5 mm/ min) | 698 (2.5 mm/ min) | 537 (2.5 mm/ min) | 444 (2.5 mm/ min) | 537 (2.5 mm/ min) |
| Density | ISO 1183, g/cm$^3$ | 0.93 | 0.921 | 0.918 | 0.914 | 0.920 | 0.924 | 0.928 |
| Melt flow index (MFI) | ASTM D1238, 180 °C/5 kg, g/10 min | / | 26.1 | 23.6 | 25.4 | 20.8 | 21.6 | 23.5 |

## FIG. 3B

**EUROPEAN SEARCH REPORT**

Application Number

EP 23 22 0452

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A<br><br>A | EP 2 719 721 B1 (JSP CORP [JP])<br>30 March 2016 (2016-03-30)<br>* claim 1 *<br>* examples 10,11; tables 1,2,6 *<br>* paragraph [0001] *<br>- - - - -<br>CN 114 874 537 A (KINGFA SCIENCE & TECHNOLOGY CO) 9 August 2022 (2022-08-09)<br>* paragraphs [0003] - [0005], [0062] - [0068] *<br>- - - - - | 1-8,<br>10-15<br>9<br><br><br>1-15 | INV.<br>C08L23/14<br>C08L53/00<br>C08L87/00 |

|  |  |  | TECHNICAL FIELDS SEARCHED (IPC) |
|---|---|---|---|
|  |  |  | C08L |

The present search report has been drawn up for all claims

| Place of search | Date of completion of the search | Examiner |
|---|---|---|
| Munich | 22 May 2024 | van Bergen, Marc |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 23 22 0452

This annex lists the patent family members relating to the patent documents cited in the above-mentioned European search report.
The members are as contained in the European Patent Office EDP file on
The European Patent Office is in no way liable for these particulars which are merely given for the purpose of information.

22-05-2024

| Patent document cited in search report | | Publication date | Patent family member(s) | | Publication date |
|---|---|---|---|---|---|
| EP 2719721 | B1 | 30-03-2016 | CN | 103724653 A | 16-04-2014 |
| | | | EP | 2719721 A1 | 16-04-2014 |
| | | | JP | 5582586 B2 | 03-09-2014 |
| | | | JP | 2014077045 A | 01-05-2014 |
| | | | KR | 20140046383 A | 18-04-2014 |
| | | | TW | 201428034 A | 16-07-2014 |
| | | | US | 2014097389 A1 | 10-04-2014 |
| CN 114874537 | A | 09-08-2022 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008297418 A
- JP 04451646 B
- JP 2006265540 A
- JP 2011006670 A
- CN 1412086 A